Europäisches Patentamt

European Patent Office

Office européen des brevets

(11) Veröffentlichungsnummer: **0 330 908**
**A2**

## (12) EUROPÄISCHE PATENTANMELDUNG

(21) Anmeldenummer: 89102563.7

(22) Anmeldetag: **15.02.89**

(51) Int. Cl.⁴: **H03G 5/22 , H03G 3/00 , G08G 1/09**

(30) Priorität: **04.03.88 DE 3807108**

(43) Veröffentlichungstag der Anmeldung:
**06.09.89 Patentblatt 89/36**

(84) Benannte Vertragsstaaten:
**AT CH DE ES FR GB IT LI SE**

(71) Anmelder: **Blaupunkt-Werke GmbH**
**Robert-Bosch-Strasse 200**
**D-3200 Hildesheim(DE)**

(72) Erfinder: **Spelter, Michael**
**Unter den Eichen 5**
**D-3200 Hildesheim(DE)**

(74) Vertreter: **Eilers, Norbert, Dipl.-Phys.**
**Blaupunkt-Werke GmbH**
**Robert-Bosch-Strasse 200**
**D-3200 Hildesheim(DE)**

(54) **Autoradio mit Verkehrsfunkdecoder.**

(57) Bei einem Autoradio werden zur Erzielung einer besseren Klangwiedergabe, insbesondere die den Bässen zugeordneten Frequenzen des NF-Übertragungsbandes angehoben. Zur Verbesserung der Sprachverständlichkeit bei einer Verkehrsdurchsage wird mittels einem vom Verkehrsfunkdecoder decodierten Durchsagekennungssignal ,die Baßanhebung während der Dauer der Verkehrsdurchsage pegelmäßig abgesenkt.

**EP 0 330 908 A2**

Fig. 2

## Autoradio mit Verkehrsfunkdecoder

Die Erfindung betrifft ein Autoradio mit Verkehrsfunkdecoder nach dem Oberbegriff des Anspruchs 1.

Da bei unterschiedlicher Lautstärke das menschliche Gehör für hohe und tiefe Frequenzen nicht gleichmäßig empfindlich ist, werden die NF-Signalwege von Empfängern mit Netzwerken versehen, die bei niedrigen bis mittleren Lautstärkeeinstellungen insbesondere eine Baßanhebung bewirken. Derartige Maßnahmen verbessern die Klangwiedergabe bei Musikübertragungen. Erfolgt jedoch bei einer für Musikwiedergabe vorteilhaften Baßeinstellung und einer normal oder gering eingestellten Lautstärke eine Verkehrsdurchsage, so ist diese oft nicht deutlich genug zu verstehen, zumal die Verständlichkeit durch das Fahrgeräusch zusätzlich beeinträchtigt wird.

Aus der DE-OS 21 20 281 ist es bekannt, während einer Verkehrsdurchsage die Lautstärke im unteren und mittleren Einstellbereich des Lautstärkeeinstellers anzuheben. Mit dieser Maßnahme wird insbesondere sichergestellt, daß eine Verkehrsdurchsage auch bei voll oder stark zurückgestelltem Lautstärkeeinsteller wahrgenommen werden kann. Die Verständlichkeit einer Verkehrsdurchsage wird hierbei nur bedingt verbessert.

Der Erfindung liegt die Aufgabe zugrunde, die Verständlichkeit einer Verkehrsdurchsage bei einem Autoradio zu verbessern.

Diese Aufgabe wird bei einem gattungsgemäßen Autoradio durch die kennzeichnenden Merkmale des Anspruchs 1 gelöst.

Die mit der Erfindung erzielten Vorteile bestehen insbesondere darin, daß die Sprachverständlichkeit einer Verkehrsdurchsage mit einem minimalen Aufwand an Schaltmitteln wesentlich verbessert wird.

Durch die in den Unteransprüchen aufgeführten Maßnahmen sind vorteilhafte Ausgestaltungen des im Anspruch 1 angegebenen Autoradios möglich.

Besonders vorteilhaft ist eine Ausgestaltung nach Anspruch 2, mit der die Baßanhebung einer Loudness-Schaltung während einer Verkehrsdurchsage unwirksam geschaltet wird. Mit einem sehr geringen Aufwand läßt sich mit Ausgestaltungen nach den Ansprüchen 3 und 4 ein am Anzapf des Lautstärkestellers ohnehin angeschlossener Kondensator unwirksam schalten.

Ein Ausführungsbeispiel der Erfindung ist in der Zeichnung dargestellt und wird im folgenden näher beschrieben.

Es zeigen

Fig. 1 ein Blockschaltbild eines Autoradios und

Fig. 2 ein Schaltbild eines NF-Netzwerkes mit einem Lautstärkesteller und einer mittels eines Durchsagekennungssignals abschaltbaren Baßanhebung.

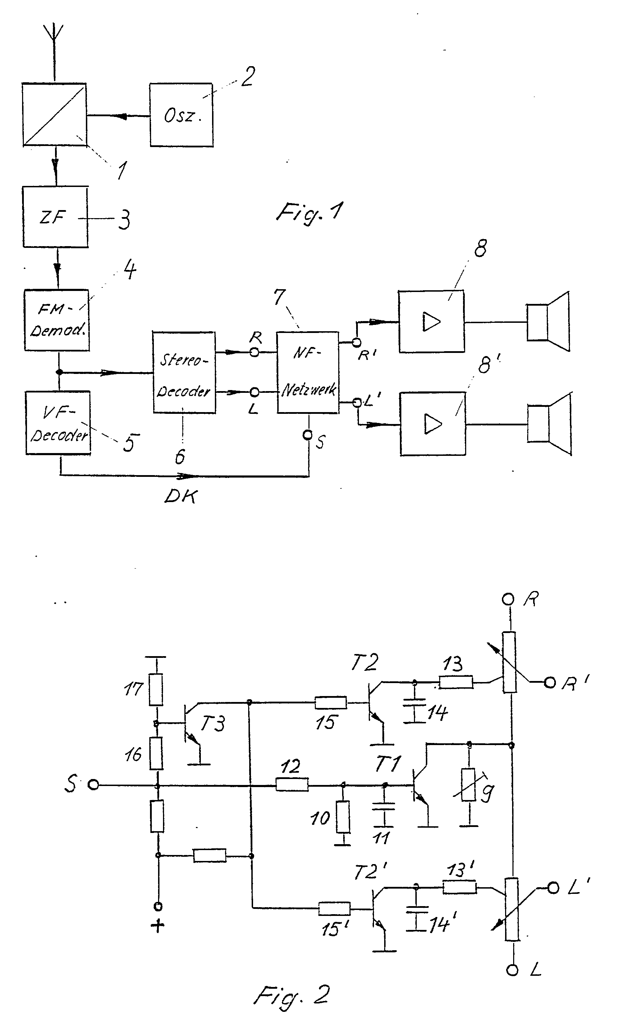

Ein in der Figur 1 dargestelltes, für den Empfang von Stereo- und Verkehrsfunksendungen ausgerüstetes Autoradio weist in an sich bekannter Weise eine HF-Eingangs- und Mischstufe 1, einen Abstimmoszillator 2, einen ZF-Verstärker 3, einen FM-Demodulator 4, einen Verkehrsfunkdecoder 5, einen Stereo-Decoder 6, ein zur Lautstärkeeinstellung sowie zur Lautstärkeanhebung bei Verkehrsfunkdurchsagen dienendes NF-Netzwerk 7 und zwei NF-Verstärker 8, 8' für die beiden NF-Signalwege auf.

Das in der Figur 2 dargestellte NF-Netzwerk 7 weist zwei Lautstärkeeinsteller P, P' auf, deren Fußpunkte miteinander verbunden und über einen einstellbaren Widerstand 9 an Masse gelegt sind. Dem Wider stand 9 ist die Kollektor-Emitterstrecke eines mit seinem Emitter an Masse liegenden NPN-Transistors T1 parallel geschaltet. Die über einen Widerstand 10 und einem ihm parallel geschalteten Kondensator 11 an Masse liegende Basis des Transistors T1 ist über einen weiteren Widerstand 12 mit einer Klemme S verbunden, der ein vom Verkehrsfunkdecoder 5 decodiertes Durchgangskennungssignal DK zugeführt wird. Der im Ruhezustand leitende Transistor T1 wird durch dieses DK-Signal nichtleitend und bewirkt damit in an sich bekannter Weise eine Anhebung des Fußpunktwiderstandes des Lautstärkestellers P, P' und damit eine Anhebung der eingestellten Lautstärke. Die dem Stereo-Decoder entnehmbaren, dem rechten bzw. dem linken Stereosignal zugeordneten NF-Signale werden über Eingangsklemmen R, L des NF-Netzwerkes 7 den Hochpunkten der Lautstärkeeinsteller P, P' zugeführt. Die Schleifer der Lautstärkeeinsteller P, P' sind über Ausgangsklemmen R', L' mit den nachgeschalteten NF-Verstärkern 8, 8' verbunden. Die Anzapfe der Lautstärkeeinsteller P, P' sind jeweils über einen Widerstand 13, 13' und über einen mit ihm in Reihe geschalteten Kondensator 14, 14' mit Masse verbunden. Jedem der Kondensatoren 14, 14' ist ein NPM-Schalttransistor T2, T2' zugeordnet, dessen Emitter mit Masse und dessen Kollektor mit dem nicht an Masse liegenden Anschluß des Kondensators 14, 14' verbunden ist. Die Basen der Transistoren T2, T2' sind über jeweils einen Widerstand 15, 15' mit dem Kollektor eines fit dem Emitter an Masse liegenden, als Inverter geschalteten NPN-Transistor T3 verbunden, dessen Basis über einen Spannungsteiler 16/17 mit der Klemme S verbunden ist.

Wird der Empfänger mit einer Lautstärkeeinstellung betrieben, bei der sich der Schleifer des Lautstärkeeinstellers P, P' unterhalb oder in der Nähe des Anzapfes befindet, so findet bei der als physiologische Lautstärkeeinstellung bekannten Schaltungsanordnung aufgrund des mit dem Anzapf verbundenen Kondensators 14, 14' eine Baßanhebung statt. Die Schalttransistoren T2, T2' befinden sich hierbei in nichtleitendem Zustand. Beim Auftreten eines im Verkehrs funkdecoder 5 demodulierten Verkehrsdurchsagesignals steuert dieses über die Klemme S und über den Transistor T3 die Schalttransistoren T2, T2' in ihren leitenden Zustand. Durch die Überbrückung der Kondensatoren 14, 14' wird die Baßanhebung unwirksam und damit die Verständlichkeit der Verkehrsdurchsage erheblich verbessert. Die Beeinflussung der Baßanhebung ist nicht an eine Beschaltung des Lautstärkeeinstellers gebunden. Sie kann auch an beliebiger Stelle im NF-Signalweg erfolgen.

**Ansprüche**

1. Autoradio mit Verkehrsfunkdecoder und mit einem NF-Übertragungsteil, bei dem im NF-Signalweg bzw. in jedem der NF-Signalwege ein die Klangfarbe beeinflussendes frequenzabhängiges NF-Netzwerk angeordnet ist,
dadurch gekennzeichnet,
daß ein vom Verkehrsfunkdecoder decodiertes Durchsagekennungssignal (DK) ein elektronisch steuerbares, die Durchlaßcharakteristik des NF-Netzwerkes (7) beeinflussendes Schaltglied (P, 13, 14, T2; P', 13', 14', T2') derart betätigt, daß die einer Baßübertragung zugeordneten unteren Frequenzanteile des übertragenen NF-Nutzsignals während einer Verkehrsdurchsage pegelmäßig abgesenkt werden.

2. Autoradio nach Anspruch 1,
dadurch gekennzeichnet,
daß das vom Verkehrsfunkdecoder decodierte Durchgangskennungssignal (DK) mittels eines elektronischen Schalters (T2, T2') die Baßanhebung einer Loudness-Schaltung unwirksam schaltet.

3. Autoradio nach Anspruch 2,
dadurch gekennzeichnet,
daß der elektronische Schalter (T2, T2') während einer Verkehrsdurchsage einen der physiologischen Lautstärkeeinstellung dienenden, mit dem Anzapf eines Lautstärkestellers (P, P') verbundenen Kondensator (14, 14') unwirksam schaltet.

4. Autoradio nach Anspruch 3,
dadurch gekennzeichnet,
daß der Anzapf des Lautstärkestellers (P, P') über einen Widerstand (13, 13') mit einem an Masse liegenden Kondensator (14, 14') verbunden ist, dem die Kollektoremitter-Strecke eines als elektronischer Schalter vorgesehenen Transistors (T2, T2') parallel geschaltet ist.

Fig. 1

Fig. 2